# EUROPEAN PATENT SPECIFICATION

(11) **EP 2 191 331 B1**
(45) Date of publication and mention of the grant of the patent: **31.05.2017**
(21) Application number: 08802330.4
(22) Date of filing: 18.09.2008
(51) Int. Cl.: G02B 27/00, G02B 17/06, G02B 5/00, G03F 7/20

(54) **PROJECTION OBJECTIVE WITH OBSCURATED PUPIL FOR MICROLITHOGRAPHY**
PROJEKTIONSOBJEKTIV MIT OBSKURISIERTER PUPILLE FÜR DIE MIKROLITHOGRAPHIE
OBJECTIF DE PROJECTION AVEC PUPILLE OBSCURCIE POUR UNE MICROLITHOGRAPHIE

(30) Priority: 21.09.2007 DE 102007046398; 21.09.2007 US 974171 P
(43) Date of publication of application: 02.06.2010
(73) Proprietor: Carl Zeiss SMT GmbH, 73447 Oberkochen (DE)
(72) Inventor: KRAEHMER, Daniel, 73457 Essingen (DE); DODOC, Aurelian, 89522 Heidenheim (DE); MANN, Hans-Juergen, 73447 Oberkochen (DE); GRUNER, Toralf, 73433 Aalen-Hofen (DE)
(74) Representative: Witte, Weller & Partner Patentanwälte mbB
(86) International application number: PCT/EP2008/007807
(87) International publication number: WO 2009/036975

(56) References cited:
- US-A- 6 031 598
- US-A1- 2005 030 504
- US-A1- 2006 001 958
- US-A1- 2006 215 137
- US-A1- 2006 232 867

## Description

The invention relates to a projection objective with obscurated pupil for microlithography, comprising a first optical surface, which has a first region provided for application of useful light, and comprising at least one second optical surface, which has a second region provided for application of useful light, a beam envelope of the useful light extending between the first region and the second region during the operation of the projection objective.

Such a projection objective for microlithography is known from the document WO 2006/069725 A1.

Projection objectives are used in microlithography in projection exposure apparatuses for the production of semiconductor components and other finely structured components. In this case, the projection objectives serve to project patterns of photomasks or optical reticles, also referred to generally as masks or reticles, onto an object coated with a light-sensitive layer with maximum resolution on a reduced scale.

In this case, in order to produce ever finer structures it is necessary on the one hand to increase the image-side numerical aperture (NA) of the projection objective and on the other hand to use ever shorter wavelengths, wavelengths of less than 20 nm, that is to say in the extreme ultraviolet (EUV) being used nowadays.

Since, in the EUV wavelength range, only materials whose transparency is not very adequate are available for the production of optical components, projection objectives for EUV lithography have exclusively reflective optical elements. Such projection objectives are correspondingly referred to as catoptric.

However, the present invention is not restricted to catoptric projection objectives in the EUV range, but rather can also be used for projection objectives used in the longer-wavelength range.

WO 2006/069725 proposes, in order to obtain a high image-side numerical aperture, obscurating the pupil of the projection objective by providing one or a plurality of the optical surfaces, mirrors in that case, with through holes through which the useful light passes. In that case, the through holes lie approximately on the optical axis.

In the case of such obscurated projection objectives, it is crucial for the imaging quality that the useful light is applied to all the optical surfaces of the projection objective which are provided for application of the useful light in the correct order and without omitting one or more of said optical surfaces before it passes into the image plane.

Precisely in the case of obscurated projection objectives, however, it can happen that scattered light passes through the through holes in the optical surfaces directly into the image plane without previously impinging on all the regions of the optical surfaces which are provided for application of useful light.

Within the meaning of the present invention, "scattered light" is understood to be not only that light which arises as a result of undesirable reflections at the optical surfaces, but also so-called over-apertured light, that is to say those light beams which have a larger aperture than the system aperture.

Within the meaning of the present invention, "beam envelope" of the useful light should be understood to be the totality of the marginal rays of the useful light bundle or in other words the envelope of the useful light beam.

The reason why scattered light passes through the through holes in the optical surfaces directly into the image plane whilst omitting specific optical surfaces may consist in the fact that said scattered light passes through the through holes at an angle of incidence that deviates from the angular range which the useful light exhibits upon passing through the through holes.

Measures for suppressing scattered light in catadioptric projection objectives, i.e. those having both reflective and refractive optical elements, are described in the document WO 2006/128613.

In a catadioptric projection objective which has three objective parts and in which the useful light is deflected from the first objective part into the second objective part by approximately 90°, it is proposed to arrange a scattered light screening diaphragm between the first and third objective parts, which diaphragm prevents the useful light from being able to pass from the first objective part directly into the third objective part whilst omitting the second objective part.

Further measures described therein for other catadioptric projection objectives relate to the application of coatings that screen scattered light on individual optical elements in the regions thereof to which the useful light is not applied.

Yet another measure described therein consists in introducing, in projection objectives, scattered light screening diaphragms into the gap between two intersecting useful light beam segments, in which the useful light beam segments do not overlap.

The document EP 1 355 194 A2 describes a catoptric projection objective in which a disc that combines a field diaphragm with an aperture diaphragm is arranged in proximity to the object plane of the projection objective. This is intended to ensure that only useful light coming from the object plane passes through the field diaphragm opening, while only useful light coming from the exposure apparatus is transmitted through the aperture diaphragm towards the object plane. The projection objective described therein does not have an obscurated pupil.

The document JP 2005/086148 A discloses a non-obscurated catoptric projection objective comprising six mirrors, a total of six scattered light diaphragms being arranged in this optical system. Each of the scattered light diaphragms serves to prevent scattered light from passing into the image plane. A truncated-cone-shaped tube is used inter alia therein as a possible configuration of a scattered light diaphragm.

The document JP 2004/246343 A describes a catoptric system having, for the suppression of scattered light, an aperture diaphragm having plate-type extensions in the propagation direction of the useful light, which serve as scattered light screening elements.

For projection objectives with obscurated pupil, the use of such a scattered light screening diaphragm is inadequate for ensuring that the scattered light does not pass directly into the image plane through the through holes in individual optical surfaces.

The invention is based on the object of specifying a projection objective with obscurated pupil for microlithography in which the imaging properties are improved by more effective suppression of scattered light.

The invention achieves this object with regard to the projection objective mentioned in the introduction by virtue of the fact that at least one tube open on the input side and on the output side in the light propagation direction and serving for screening scattered light is arranged between the first optical surface and the second optical surface, said tube extending in the propagation direction of the useful light over at least a partial length of the beam envelope and circumferentially surrounding the beam envelope.

In the projection objective according to the invention, the beam envelope of the useful light between two optical surfaces is enclosed by a tube which is circumferentially closed but open at the ends. The fact that the beam envelope is enclosed by the at least one tube means that the useful light can pass undisturbed through the tube, whereas scattered light, that is to say that light which arises as a result of undesirable reflections, or over-aperture light, having a different propagation direction with respect to the beam envelope of the useful light, is effectively screened by the tube. For this purpose, the at least one tube can be absorbent on the inside and/or on the outside.

In one preferred configuration, the beam envelope of the useful light between the first optical surface and the second optical surface is a first beam envelope and is overlapped by a second beam envelope of the useful light over a partial length of the first beam envelope, the tube extending over at least a partial length of the overlap-free partial region of the first beam envelope.

In this case, it is advantageous that the at least one tube ensures the undisturbed propagation of the useful light in the overlap region of the two beam envelopes.

In this case, it is preferred if the tube extends over the entire length of the overlap-free partial region of the first beam envelope.

In this case, it is advantageous that the scattered light suppression by the at least one tube is particularly effective because the beam envelope of the useful light is enclosed over the maximum possible length in the light propagation direction.

It generally holds true that the at least one tube ensures an optimum scattered light suppression if it surrounds the beam envelope of the useful light between the two optical surfaces over preferably at least 50% of the beam envelope length, preferably over the entire beam envelope length.

In a further preferred configuration, the tube surrounds the beam envelope at a minimal distance, for example at a distance of preferably less than 2 mm, less than 1 mm, or even less than 0.2 mm, but contactlessly.

If the tube surrounds the beam envelope contactlessly, this prevents the tube from disturbing the propagation of the useful light. The smaller the distance between the tube and the beam envelope of the useful light, the more effective the scattered light screening by the tube is, too, because even that scattered light whose propagation direction deviates only slightly from that of the beam envelope is effectively prevented from propagating by the tube.

In a further preferred configuration, an intermediate image is generated between the first optical surface and the second optical surface, and the tube is arranged at least in proximity to the intermediate image.

The beam envelope of the useful light has the smallest circumference in the region of an intermediate image, such that the region of the intermediate image is particularly well suited to the arrangement of the at least one tube because the at least one tube can likewise be formed with a small circumference, such that the at least one tube does not occupy a large structural space within the projection objective.

In a further preferred configuration, the geometrical shape of the interior of the tube is adapted to the shape of the beam envelope.

This measure is advantageous particularly in conjunction with one of the measures mentioned above according to which the tube surrounds the beam envelope of the useful light at a minimal distance, because, as a result of the adaptation of the geometrical shape of the interior of the tube to the shape of the beam envelope, said minimal distance is complied with over the entire circumference of the beam envelope and over the entire length over which the tube extends.

In one preferred practical configuration, if the beam envelope is truncated cone shaped, the tube is likewise formed in truncated-cone-shaped fashion.

If the beam envelope is double truncated cone shaped, the tube is preferably formed in double-truncated-cone-shaped fashion or at least two truncated-cone-shaped tubes surround the beam envelope.

A double-truncated-cone-shaped form of the beam envelope of the useful light is advantageous in particular at an intermediate image since the beam envelope of the useful light both upstream of the intermediate image and downstream of the intermediate image is circumferentially enclosed by the one double-truncated-cone-shaped tube or the two truncated-cone-shaped tubes.

In a further preferred configuration, a third optical surface provided with a through hole is arranged between the first optical surface and the second optical surface, the through hole serving for the passage of the useful light, and the tube being arranged in or in the region of the through hole.

This measure has the further advantage that the propagation of scattered light through the through hole in an optical surface can be effectively suppressed, while the useful light passes unimpeded through the through hole, to be precise through the tube. The present invention can advantageously be applied to catoptric projection objectives with obscurated pupil, in particular to projection objectives for EUV microlithography.

Further advantages and features will become apparent from the description below and the accompanying drawing.

It goes without saying that the features mentioned above and those yet to be explained below can be used not only in the combination respectively specified, but also in other combinations or by themselves, without departing from the scope of the present invention.

Exemplary embodiments of the invention are illustrated in the drawing and are described below with reference to said drawing, in which:
- Figure 1: shows a first exemplary embodiment of a projection objective with obscurated pupil for microlithography;
- Figure 2: shows a tube for screening scattered light, which can be used in the projection objective in Figure 1;
- Figure 3: shows a further exemplary embodiment of a projection objective with obscurated pupil for microlithography;
- Figure 4: shows a tube for use in the projection objective in Figure 3; and
- Figure 5: shows yet another exemplary embodiment of a projection objective with obscurated pupil for microlithography.

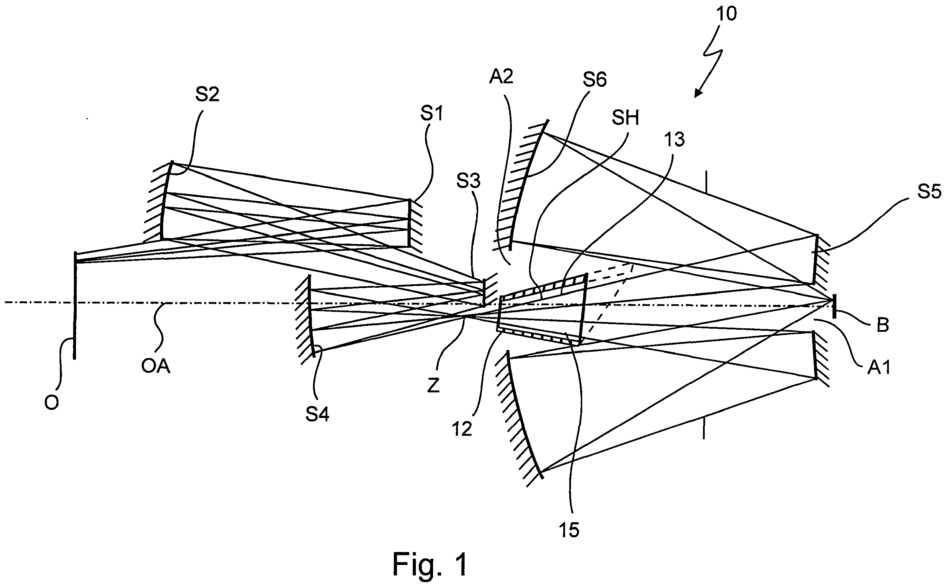

Figure 1 illustrates a projection objective - provided with the general reference symbol 10 - with obscurated pupil for microlithography. The projection objective 10 has six optical surfaces S1, S2, S3, S4, S5 and S6 between an object plane O and an image plane B as seen in the light propagation direction. The optical surfaces S1 to S6 are all mirrors, such that the projection objective 10 is a catoptric projection objective.

An optical axis of the projection objective 10 is designated by OA.

The optical surfaces S1 to S6 each have a region provided for application of useful light, the illustration in Figure 1 illustrating the optical surfaces S1 to S6 exclusively with their regions provided for application of useful light.

Figure 1 also illustrates the beam path of the useful light. The beam envelope SH of the useful light is illustrated, that is to say the beam cone formed by the totality of the marginal rays of the useful light beam bundle, of which two marginal rays 13 and 15 are illustrated here.

An intermediate image Z is furthermore situated between the optical surfaces S4 and S5. On account of the intermediate image Z, the beam envelope SH of the useful light between the optical surfaces S4 and S5 has the shape of a double cone or double truncated cone, the circumferentially narrowest location of which lies in the intermediate image Z.

The optical surface S5 has a through hole A1 and the optical surface S6 has a through hole A2, through which the useful light passes in each case. The useful light passes through the through hole A2 on the way from the optical surface S4 to the optical surface S5, and the useful light passes through the through hole A1 proceeding from the optical surface S6 to the image plane B.

In order, then, to prevent scattered light - which is generated for example at one of the optical surfaces S1, S2, S3 or S4 or which comprises over-aperture light - from passing through the through hole A2 and through the through hole A1 directly into the image plane B, the beam envelope SH of the useful light between the optical surfaces S4 and S5 is surrounded by a tube 12 over a partial length of the beam envelope SH, said tube screening scattered light or preventing it from propagating.

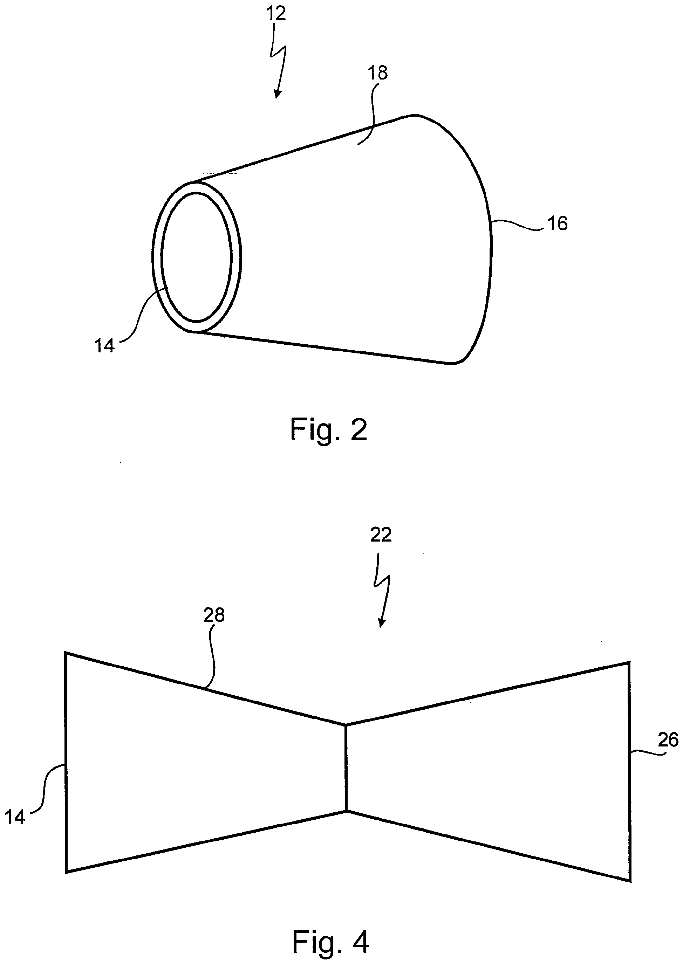

The tube 12 is illustrated by itself in figure 2. The tube 12 is open at an input side 14 and at an output side 16, that is to say has no material there, not even a material that is transparent to the useful light.

The tube 12 has a circumferential wall 18, which, by contrast, is fully circumferentially closed and preferably absorbent on the inside and/or on the outside.

In accordance with Figure 1, the tube 12 surrounds the beam envelope of the useful light between the optical surfaces S4 and S5 only over a partial length, to be precise in the region in which the beam envelope of the useful light does not overlap the beam envelope of the useful light between the optical surfaces S3 and S4 or the beam envelope between the optical surfaces S5 and S6 or the beam envelope between the optical surface S6 and the image plane.

For better utilization of the overlap-free region of the beam envelopes, the tube 12 can also have a shape such as is supplemented by interrupted lines in Figure 1.

In this case, therefore, the tube 12 extends over the entire length of the beam envelope of the useful light between the optical surfaces S4 and S5 in which said beam envelope does not overlap the beam envelopes between the optical surfaces S3 and S4, or S5 and S6, or S6 and the image plane.

In the exemplary embodiment in accordance with Figures 1 and 2, the tube 12 has the shape of a truncated cone, in which case the end sides of the truncated cone need not necessarily run parallel to one another, as is shown by interrupted lines from the illustration in Figure 1. Within the meaning of the present invention, "truncated cone shaped" encompasses all geometries in which the tube widens rectilinearly in diameter from one end to the other, in which case the base areas of the tube can be any closed one-dimensional curves, that is to say including non-circular curves.

The tube 12 surrounds the beam envelope of the useful light between the optical surfaces S4 and S5 at as minimal a distance as possible, but without touching the beam envelope SH.

In the projection objective 10, the tube 12 is arranged in the vicinity of the intermediate image Z, but cannot reach as far as the intermediate image Z for structural reasons owing to the optical surface S3.

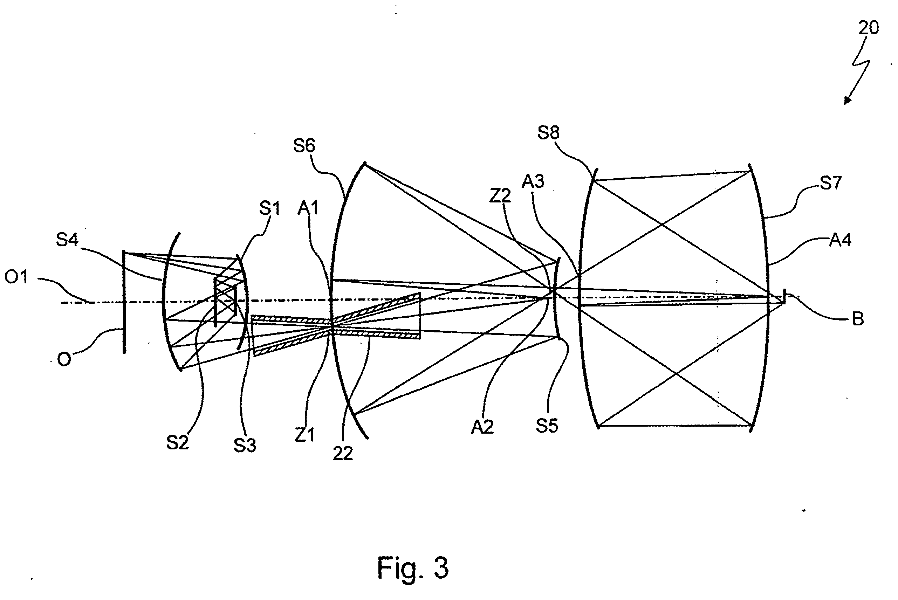

Figure 3 illustrates a further exemplary embodiment of a projection objective 20 with obscurated pupil for microlithography.

The projection objective 20 has eight optical surfaces S1 to S8 between an object plane O and an image plane B in the sequence of light propagation, the optical surface S6 having a through hole A1, the optical surface S5 having a through hole A2, the optical surface S8 having a through hole A3 and the optical surface S7 having a through hole A4.

The optical surfaces S1 to S8 are all realized by mirrors, such that the projection objective 20 is a catoptric projection objective. In contrast to the illustration in accordance with Figure 1, the illustration in Figure 3 illustrates the optical surfaces S1 to S8 symmetrically with respect to the optical axis OA, that region of each optical surface to which the useful light is applied in each case resulting from the beam envelope of the useful light depicted in Figure 3 at each optical surface S1 to S8. In contrast to Figure 1, the obscurated partial region of the beam bundle is not illustrated in Figure 3.

The arrangement of the optical surfaces S1 to S8 generates a first intermediate image at Z1 and a second intermediate image at Z2.

A tube 22 is arranged between the optical surfaces S4 and S5, said tube circumferentially surrounding the beam envelope of the useful light between the optical surfaces S4 and S5, the tube 22 extending over a partial length of the beam envelope of the useful light between the optical surfaces S4 and S5 in which the useful light does not overlap the useful light between the optical surfaces S3 and S4 and S5 and S6 and between the optical surface S6 and the image plane.

The tube 22 surrounds the beam envelope of the useful light in the intermediate image Z1 and on both sides of the intermediate image Z1, as revealed in Figure 3.

Furthermore, the tube 22 passes through the through hole A1 in the optical surface S6, which makes it possible for the tube 22 to be mechanically fixed in particular to the through hole A1.

Since the beam envelope of the useful light on both sides of the intermediate image Z1 has the shape of a double truncated cone, the tube 22 is advantageously likewise formed as a double truncated cone.

Figure 4 illustrates the tube 22 by itself.

Like the tube 12, the tube 22 is open at its longitudinal ends 24 and 26 and has a wall 28 that is opaque to light in the wavelength range of interest and is preferably absorbent on the inside and/or on the outside.

Instead of the double-truncated-cone-shaped tube 22, it is also possible to arrange two tubes in accordance with Figure 2 in the place of the tube 22 in the projection objective 20 in Figure 3, these tubes then correspondingly being arranged with their narrow ends facing one another.

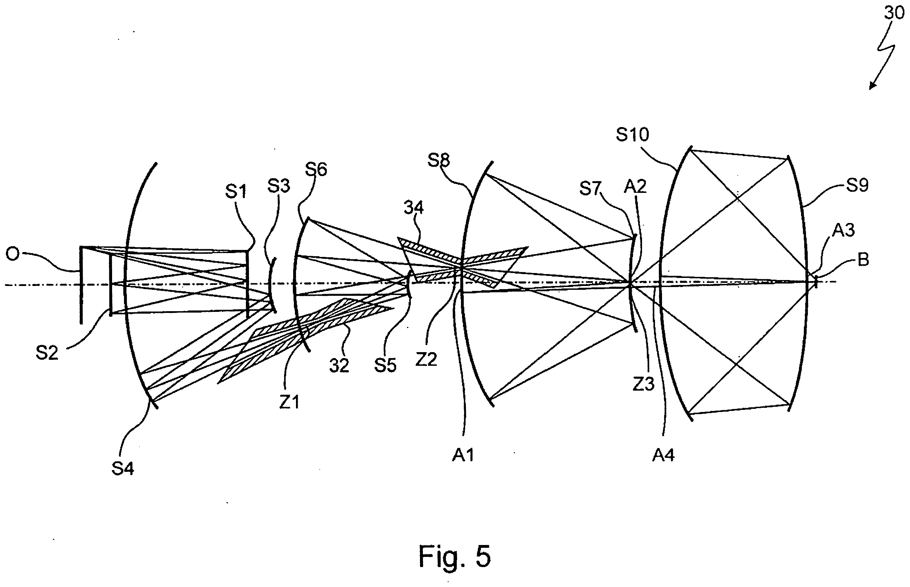

Figure 5 illustrates yet another exemplary embodiment of a projection objective 30 with obscurated pupil for microlithography.

The projection objective 30 has a total of ten optical surfaces S1 to S10 between an object plane O and an image plane B, said optical surfaces being realized as mirrors, such that the projection objective 30 is catoptric.

The projection objective 30 generates three intermediate images at Z1, Z2 and Z3. As in Figure 3, the obscurated partial region of the beam bundle is not illustrated in Figure 5.

In the projection objective 30, the beam envelope of the useful light in the region of the intermediate image Z1 between the optical surfaces S4 and S5 is surrounded by a tube 32 over a partial length that is free of overlaps with adjacent beam envelopes of the useful light, and, in addition, the beam envelope of the useful light between the optical surfaces S6 and S7 is surrounded by a second tube 34.

The tubes 32 and 34 essentially correspond to the tube 22 in accordance with the exemplary embodiment in Figure 3.

In the region of the intermediate image Z2, the optical surface S8 has a through hole A1, in which the tube 34 is advantageously arranged. Further through holes are situated at the optical surfaces S7, S9 and S10, said through holes being designated by A2, A3 and A4.

The projection objectives 10, 20 and 30 described above are suitable in particular for use in EUV lithography.

## Claims

1. Projection objective with obscurated pupil for microlithography, comprising a first optical surface (S4) which has a first region provided for application of useful light, and comprising at least one second optical surface (S5; S7), which has a second region provided for application of useful light, and comprising a third optical surface (S6; S8) provided with a through hole which is arranged between the first optical surface (S4) and the second optical surface (S5;S7), the through hole serving for the passage of the useful light, a beam envelope (SH) of the useful light extending between the first region and the second region during the operation of the projection objective, **characterized in that** at least one tube (12; 22; 32, 34) open on the input side and on the output side in the light propagation direction and configured for screening scattered light is arranged between the first optical surface (S4) and the second optical surface (S5; S7), the wall of said tube (12; 22; 32, 34) being opaque in the wavelength range of the useful light, and said tube (12; 22; 32, 34) extending in the propagation direction of the useful light over at least a partial length of the beam envelope (SH) and circumferentially surrounding the beam envelope (SH).

2. Projection objective according to Claim 1, **characterized in that** the beam envelope (SH) of the useful light between the first optical surface (S4) and the second optical surface (S5; S7) is a first beam envelope and is overlapped by a second beam envelope of the useful light over a partial length of the first beam envelope, the tube (12; 22; 32, 34) extending over at least a partial length of the overlap-free partial region of the first beam envelope.

3. Projection objective according to Claim 2, **characterized in that** the tube (12; 22; 32, 34) extends over the entire length of the overlap-free partial region of the first beam envelope.

4. Projection objective according to any of Claims 1 to 3, **characterized in that** the tube (12; 22; 32, 34) surrounds the beam envelope (SH) at a minimal distance, but contactlessly.

5. Projection objective according to Claim 4, **characterized in that** the distance is less than 2 mm, more preferably less than 1 mm, more preferably less than 0.2mm.

6. Projection objective according to any of Claims 1 to 5, **characterized in that** an intermediate image (Z; Z1, Z2; Z1, Z2, Z3) is generated between the first optical surface (S4) and the second optical surface (S5), and **in that** the tube (12; 22; 32, 34) is arranged at least in proximity to the intermediate image (Z; Z1, Z2; Z1, Z2, Z3).

7. Projection objective according to any of Claims 1 to 6, **characterized in that** the geometrical shape of the interior of the tube (12; 22; 32, 34) is adapted to the shape of the beam envelope (SH).

8. Projection objective according to Claim 7, **characterized in that** the tube (12; 22; 32, 34) is formed in truncated-cone-shaped fashion.

9. Projection objective according to Claim 7 or 8, **characterized in that** the tube (22; 32, 34) is formed in double-truncated-cone-shaped fashion or at least two truncated-cone-shaped tubes (12) surround the beam envelope.

10. Projection objective according to any of Claims 1 to 9, **characterized in that** the tube (12; 22; 34) is arranged in or in the region of the through hole.

11. Projection objective according to any of Claims 1 to 10, **characterized in that** it is catoptric.

12. Projection objective according to Claim 11, **characterized in that** it is designed for EUV microlithography.

## Patentansprüche

1. Projektionsobjektiv mit obskurierter Pupille für die Mikrolithographie, mit einer ersten optischen Fläche (S4), die einen ersten Bereich aufweist, der zur Beaufschlagung mit Nutzlicht vorgesehen ist, und mit zumindest einer zweiten optischen Fläche (S5, S7), die einen zweiten Bereich aufweist, der zur Beaufschlagung mit Nutzlicht vorgesehen ist, und umfassend eine zwischen der ersten optischen Fläche (S4) und der zweiten optischen Fläche (S5, S7) angeordnete mit einer Durchbrechung versehene dritte optische Fläche (S6, S8), wobei die Durchbrechung dem Durchgang des Nutzlichts dient, wobei sich zwischen dem ersten Bereich und dem zweiten Bereich im Betrieb des Projektionsobjektivs eine Strahlhülle (SH) des Nutzlichts erstreckt, **dadurch gekennzeichnet, dass** zwischen der ersten optischen Fläche (S4) und der zweiten optischen Fläche (S5, S7) zumindest eine in Lichtausbreitungsrichtung eingangsseitig und ausgangsseitig offene Röhre (12; 22; 32, 34) zur Abschirmung von Streulicht angeordnet ist, deren Wand im Wellenlängenbereich des Nutzlichts undurchlässig ist, und die sich in Ausbreitungsrichtung des Nutzlichts über zumindest eine Teillänge der Strahlhülle (SH) erstreckt und die Strahlhülle (SH) umfänglich umgibt.

2. Projektionsobjektiv nach Anspruch 1, **dadurch gekennzeichnet, dass** die Strahlhülle (SH) des Nutzlichts zwischen der ersten optischen Fläche (S4) und der zweiten optischen Fläche (S5, S7) eine erste Strahlhülle ist und von einer zweiten Strahlhülle des Nutzlichts über eine Teillänge der ersten Strahlhülle überlappt wird, und wobei sich die Röhre (12; 22; 32, 34) über zumindest eine Teillänge des überlappungsfreien Teilbereichs der ersten Strahlhülle erstreckt.

3. Projektionsobjektiv nach Anspruch 2, **dadurch gekennzeichnet, dass** sich die Röhre (12; 22; 32, 34) über die gesamte Länge des überlappungsfreien Teilbereichs der ersten Strahlhülle erstreckt.

4. Protektionsobjektiv nach einem der Ansprüche 1 bis 3, **dadurch gekennzeichnet, dass** die Röhre (12; 22; 32, 34) die Strahlhülle (SH) mit minimalem Abstand, jedoch berührungsfrei umgibt.

5. Projektionsobjektiv nach Anspruch 4, **dadurch gekennzeichnet, dass** der Abstand kleiner als 2 mm, weiter vorzugsweise kleiner als 1 mm, weiter vorzugsweise kleiner als 0,2 mm ist.

6. Projektionsobjektiv nach einem der Ansprüche 1 bis 5, **dadurch gekennzeichnet, dass** zwischen der ersten optischen Fläche (S4) und der zweiten optischen Fläche (S5) ein Zwischenbild (Z; Z1, Z2; Z1, Z2, Z3) erzeugt wird, und dass die Röhre (12; 22; 32, 34) zumindest in Nähe des Zwischenbildes (Z; Z1, Z2; Z1, Z2, Z3) angeordnet ist.

7. Projektionsobjektiv nach einem der Ansprüche 1 bis 6, **dadurch gekennzeichnet, dass** die geometrische Form des Innenraums der Röhre (12; 22; 32, 34) an die Form der Strahlhülle (SH) angepasst ist.

8. Projektionsobjektiv nach Anspruch 7, **dadurch gekennzeichnet, dass** die Röhre (12; 22; 32, 34) kegelstumpfförmig ausgebildet ist.

9. Projektionsobjektiv nach Anspruch 7 oder 8, **dadurch gekennzeichnet, dass** die Röhre (22; 32, 34) doppelkegelstumpfförmig ausgebildet ist oder zumindest zwei kegelstumpfförmige Röhren (12) die Strahlhülle umgeben.

10. Projektionsobjektiv nach einem der Ansprüche 1 bis 9, **dadurch gekennzeichnet, dass** die Röhre (12; 22; 34) in oder im Bereich der Durchbrechung angeordnet ist.

11. Projektionsobjektiv nach einem der Ansprüche 1 bis 10, **dadurch gekennzeichnet, dass** es katoptrisch ist.

12. Projektionsobjektiv nach Anspruch 11, **dadurch gekennzeichnet, dass** es für die EUV-Mikrolithografie ausgelegt ist.

## Revendications

1. Objectif de projection avec pupille obscurcie pour microlithographie, comprenant une première surface optique (S4) qui a une première région prévue pour l'application de lumière utile, et comprenant au moins une deuxième surface optique (S5 ; S7), qui a une deuxième région prévue pour l'application de lumière utile, et comprenant une troisième surface optique (S6 ; S8) pourvue d'un trou traversant qui est disposée entre la première surface optique (S4) et la deuxième surface optique (S5 ; S7), le trou traversant servant au passage de la lumière utile, une enveloppe de faisceau (SH) de la lumière utile s'étendant entre la première région et la deuxième région pendant le fonctionnement de l'objectif de projection, **caractérisé en ce qu'**au moins un tube (12 ; 22 ; 32, 34) ouvert sur le côté entrée et sur le côté sortie dans la direction de propagation de la lumière et configuré pour bloquer la lumière diffusée est disposé entre la première surface optique (S4) et la deuxième surface optique (S5 ; S7), la paroi dudit tube (12 ; 22 ; 32, 34) étant opaque dans la gamme de longueurs d'onde de la lumière utile, et ledit tube (12 ; 22 ; 32, 34) s'étendant dans la direction de propagation de la lumière utile sur au moins une longueur partielle de l'enveloppe de faisceau (SH) et entourant circonférentiellement l'enveloppe de faisceau (SH).

2. Objectif de projection selon la revendication 1, **caractérisé en ce que** l'enveloppe de faisceau (SH) de la lumière utile entre la première surface optique (S4) et la deuxième surface optique (S5 ; S7) est une première enveloppe de faisceau et est chevauchée par une deuxième enveloppe de faisceau de la lumière utile sur une longueur partielle de la première enveloppe de faisceau, le tube (12 ; 22 ; 32, 34) s'étendant sur au moins une longueur partielle de la région partielle sans chevauchement de la première enveloppe de faisceau.

3. Objectif de projection selon la revendication 2, **caractérisé en ce que** le tube (12 ; 22 ; 32, 34) s'étend sur la longueur entière de la région partielle sans chevauchement de la première enveloppe de faisceau.

4. Objectif de projection selon l'une quelconque des revendications 1 à 3, **caractérisé en ce que** le tube (12 ; 22 ; 32, 34) entoure l'enveloppe de faisceau (SH) à une distance minimale, mais sans contact.

5. Objectif de projection selon la revendication 4, **caractérisé en ce que** la distance est inférieure à 2 mm, mieux inférieure à 1 mm, mieux encore inférieure à 0,2 mm.

6. Objectif de projection selon l'une quelconque des revendications 1 à 5, **caractérisé en ce qu'**une image intermédiaire (Z ; Z1, Z2 ; Z1, Z2, Z3) est générée entre la première surface optique (S4) et la deuxième surface optique (S5), et **en ce que** le tube (12 ; 22 ; 32, 34) est disposé au moins à proximité de l'image intermédiaire (Z ; Z1, Z2 ; Z1, Z2, Z3).

7. Objectif de projection selon l'une quelconque des revendications 1 à 6, **caractérisé en ce que** la forme géométrique de l'intérieur du tube (12 ; 22 ; 32, 34) est adaptée à la forme de l'enveloppe de faisceau (SH).

8. Objectif de projection selon la revendication 7, **caractérisé en ce que** le tube (12 ; 22 ; 32, 34) est formé à la manière d'un cône tronqué.

9. Objectif de projection selon la revendication 7 ou 8, **caractérisé en ce que** le tube (22 ; 32, 34) est formé à la manière d'un double cône tronqué ou au moins deux tubes en forme de cône tronqué (12) entourent l'enveloppe de faisceau.

10. Objectif de projection selon l'une quelconque des revendications 1 à 9, **caractérisé en ce que** le tube (12 ; 22 ; 34) est disposé dans le ou dans la région du trou traversant.

11. Objectif de projection selon l'une quelconque des revendications 1 à 10, **caractérisé en ce qu'**il est catoptrique.

12. Objectif de projection selon la revendication 11, **caractérisé en ce qu'**il est conçu pour la microlithographie EUV.
